# EUROPEAN PATENT APPLICATION

(11) **EP 2 214 081 A1**
(43) Date of publication of application: **04.08.2010**
(21) Application number: 09170618.4
(22) Date of filing: 17.09.2009
(51) Int. Cl.: G06F 3/03, G06F 3/033, H03K 17/96

(54) **Optical pointing device and portable electronic device having the same**

(30) Priority: 30.01.2009 KR 20090007546; 24.03.2009 KR 20090025131; 27.05.2009 KR 20090046318
(71) Applicant: Crucialtec Co., Ltd., Baebang-Myun Asan-Si Ch'ungch'ong namdo 336-795 (KR)
(72) Inventor: Ahn, Keon Joon, Gyeonggi-do (KR); Kim, Jae Dong, Seoul (KR); Kim, Jong UK, Gyeonggi-do (KR); Park, Sang Il, Seoul (KR); Lee, Seung Hun, Seoul (KR); Lee, Hyun Youl, Gyeonggi-do (KR)
(74) Representative: Habermann, Gert

(57) **Abstract**

Disclosed herein is an optical pointing device as a user interface for electronic devices such as communication terminals and the like. The optical pointing device includes a light receiving part, an optical unit transferring light to the light receiving part and including a reflection part disposed in an optical path, a frame body integrally formed with the reflection part to support the reflection part, a cover covering the frame body and having an interface surface, and a light source illuminating the cover. The optical pointing device reduces the number of components and permits convenient and easy assembly, thereby significantly improving productivity while reducing assembly defect.

## Description

### BACKGROUND OF THE INVENTION

### Field of the Invention

The present invention relates to an optical pointing device and electronic devices having the same, and, more particularly, to an optical pointing device applicable to user interfaces of electronic devices, such as mobile terminals and the like, and to portable electronic devices including the same.

### Description of the Related Art

Generally, electronic devices, such as mobile terminals, personal digital assistants (PDAs), and the like, employ a user interface in the form of a keypad.

More specifically, a conventional portable electronic device includes a keypad, which is provided with a plurality of buttons for inputting numerals, letters or marks, so that a user can input desired data such as figures or words into the electronic device or can select menus of the electronic device by pressing the buttons on the keypad.

Further, the portable electronic device is provided with a display screen to display data and/or information associated therewith input by the user through the keypad.

Recently, wireless mobile communication services and wireless Internet services such as WIBRO (Wireless Broadband) Internet services are commercialized to provide communication services or Internet services to electronic devices, and Windows operating systems such as Windows CE and the like are installed on portable electronic devices such as mobile terminals and PDAs to support a Graphical User Interface (GUI).

Further, with development of communication technology, the portable electronic device supplies a variety of annexed services and the GUI-based Windows operating system facilitates supply of the annexed services from the portable electronic device.

Examples of user interfaces for more convenient use of the conventional electronic devices include a mouse, a touch pad, a pointing device, and the like. In recent years, optical pointing devices for electronic devices have been developed, which detect an optical signal varied in response to movement of a finger as an object to move a pointer such as a cursor or to receive desired information and/or commands.

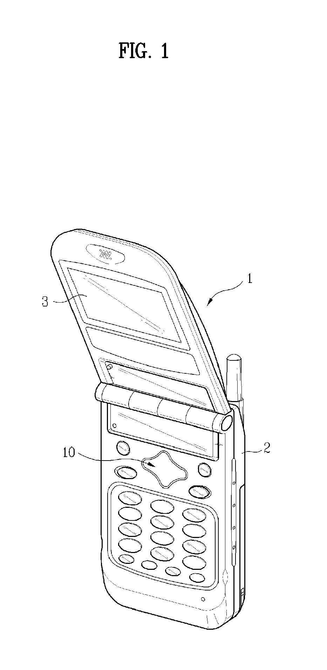

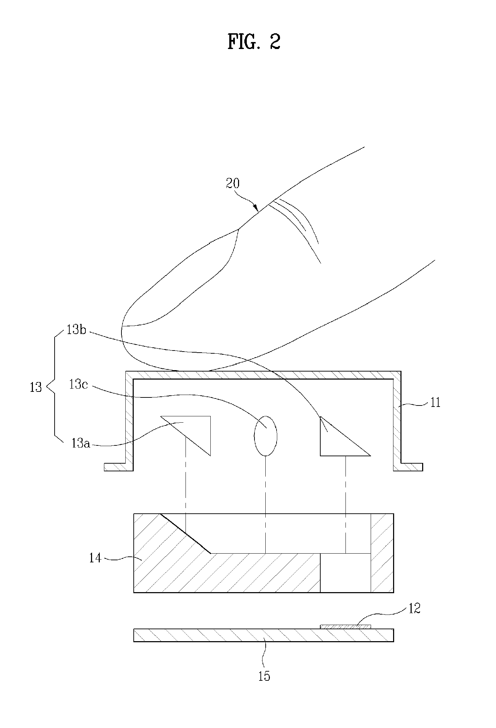

Referring to Figs. 1 and 2, a conventional optical pointing device 10 includes a light source (not shown), a cover 11, an image sensor 12 for detecting an optical signal, an optical unit 13 for guiding light to the image sensor 12, and a holder 14 for receiving the optical unit 13.

The optical pointing device 10 may be provided separately from an electronic device 1 to be connected thereto via wired or wireless communication. Alternatively, the optical pointing device 10 may be directly mounted on a body 2 of the electronic device 1. If the optical pointing device 10 is integrated with the electronic device 1, it is desirable that the optical pointing device 10 be as thin as possible for slimness of the electronic device 1.

The cover 11 is formed on an outer surface thereof with a manipulation surface, that is, an interface surface, with which an object 20, such as a finger, will be brought into contact. The image sensor 12 is disposed on a PCB 15 which processes input signals.

Accordingly, when the object 20, such as a finger, comes into contact with the manipulation surface and moves thereon, an optical signal input to the image sensor 12 is converted into an electrical signal in response to movement of the finger. More specifically, with the object 20 separated from the manipulation surface, light emitted from the light source passes through the cover 11 and is discharged outside the cover 11.

On the other hand, when the object 20, that is, the finger, comes into contact with the manipulation surface, light emitted from the light source is reflected by the cover 11 and reaches the image sensor 12 through the optical unit 13.

As the object 20 contacts and moves on the manipulation surface, the optical signal detected by the image sensor 12 is varied, thereby allowing movement of a cursor or pointer to be displayed on the display screen of the electronic device 1.

Detection of the optical signal and image control by the image sensor 12 are similarly carried out to those in an optical mouse of a computer, and a detailed description thereof will be omitted herein.

On the other hand, the optical unit 13 is assembled to the holder 14, which is formed with a receiving groove such that the optical unit 13 is mounted on the receiving groove of the holder 14 and secured inside the cover 11.

The optical unit 13 includes one or more prisms 13a, 13b and an imaging lens 13c disposed in an optical path, which constitute an optical or imaging system for transferring light, i.e. light reflected by the object, to the image sensor 12 through reflection and/or refraction of light.

The prisms 13a, 13b are made of a glass or plastic material and change the traveling course of light through refraction, and the imaging lens 13c serves to focus light.

### SUMMARY OF THE INVENTION

The present invention is directed to solving the above and other problems of the related art, and an aspect of the invention is to provide an optical pointing device which has a reduced number of components and a simple structure, and an electronic device including the same.

Another aspect of the invention is to provide an optical pointing device having a slim thickness, and an electronic device including the same.

In accordance with an aspect, the invention provides an optical pointing device including: a light receiving part; an optical unit transferring light to the light receiving part and including a reflection part disposed in an optical path; a frame body integrally formed with the reflection part to support the reflection part; a cover covering the frame body and having an interface surface; and a light source illuminating the cover.

In accordance with another aspect, the invention provides an optical pointing device including: a light receiving part; an optical unit transferring light to the light receiving part and including an imaging lens and a reflection part disposed in an optical path, the reflection part having a pair of reflection surfaces; a frame body integrally formed with the reflection part to support the reflection part; a cover covering the frame body and having an interface surface; a light source provided to the frame body to illuminate the cover; and a light blocking part disposed in the optical path to block a predetermined portion of light traveling along the optical path and having a light passing portion formed to a predetermined size in the optical path by reducing a cross-sectional area of the optical path through which the light passes.

In accordance with a further aspect, the invention provides a portable electronic device including: a device body including a display screen; and an optical pointing device mounted on the device body. Here, the optical pointing device includes: a light receiving part; an optical unit transferring light to the light receiving part and including a reflection part disposed in an optical path; and a frame body integrally formed with the reflection part to support the reflection part.

According to embodiments of the invention, the optical pointing device has reflective surfaces integrated with a conventional holder, that is, the frame body, which supports and secures the optical unit in place, thereby improving assembly of the optical pointing device and reducing the number of components to reduce manufacturing costs.

### BRIEF DESCRIPTION OF THE DRAWINGS

The above and other aspects, features and advantages of the invention will become apparent from the following detailed description of exemplary embodiments given in conjunction with the accompanying drawings, in which:

Fig. 1 is a perspective view of an example of an electronic device including a conventional optical pointing device;

Fig. 2 is an exploded side-section view of the conventional optical pointing device;

Fig. 3 is an exploded perspective view of an optical pointing device according to a first embodiment of the present invention;

Fig. 4 is a side-sectional view of the optical pointing device according to the first embodiment of the present invention;

Fig. 5 is a side-sectional view illustrating a light transferring path in the optical pointing device of Fig. 4;

Fig. 6 is an exploded perspective view of an optical pointing device according to a second embodiment of the present invention;

Fig. 7 is a side-sectional view of the optical pointing device according to the second embodiment of the present invention;

Fig. 8 is a side-sectional view illustrating a light transferring path in the optical pointing device of Fig. 7;

Fig. 9 is an exploded perspective view of an optical pointing device according to a third embodiment of the present invention; and

Fig. 10 is a side-sectional view of the optical pointing device according to the third embodiment of the present invention.

### DETAILED DESCRIPTION OF EMBODIMENTS

Exemplary embodiments of the invention will hereinafter be described in detail with reference to the accompanying drawings. In the detailed description of the embodiments, like components will be denoted by like reference numerals and a repetitious description thereof will be omitted herein.

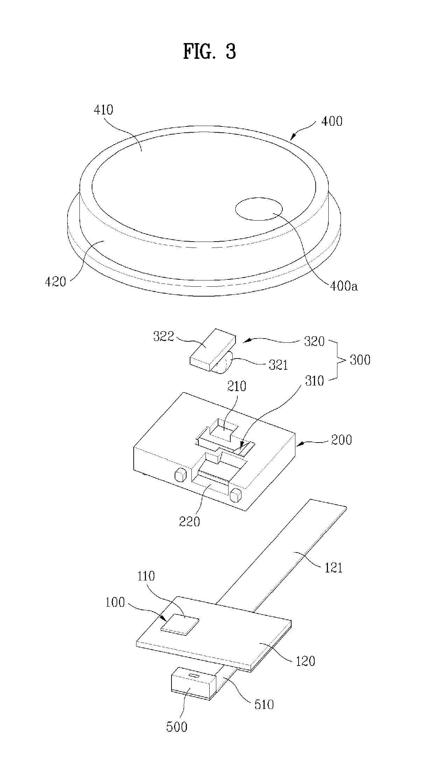

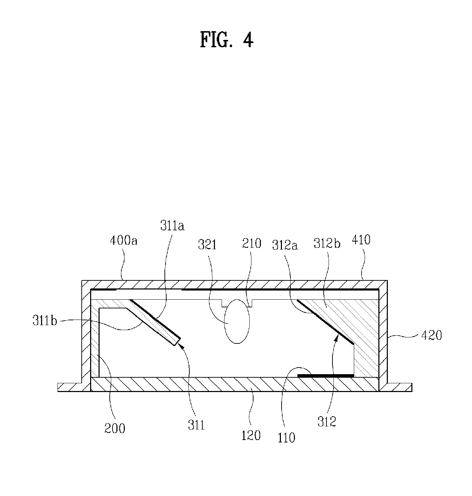

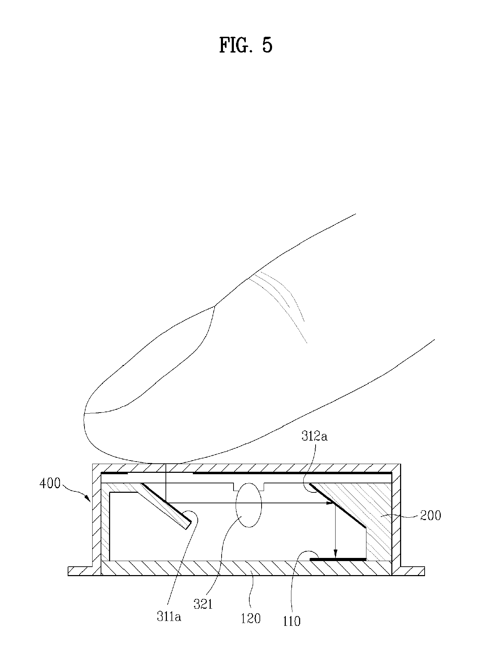

Referring to Figs. 3 to 5, an optical pointing device according to a first embodiment will be described.

In Figs. 3 to 5, the optical pointing device according to the first embodiment includes a light receiving part 100, a frame body 200, and an optical unit 300.

The light receiving part 100 detects light to sense an object, and the optical unit 300 transfers the light to the light receiving part 100 and includes a reflection part 310 disposed in an optical path to reflect the light. The frame body 200 supports the reflection part 310, which is integrally formed with the frame body 200 and is aligned in the optical path.

In a conventional optical pointing device, optical members 13a, 13b (see Fig. 2) for changing the optical path are formed separately from a holder 14 (see Fig. 2) and are assembled to the holder 14 to be supported thereby. According to this embodiment, however, the reflection part 310 corresponding to the conventional optical members for changing the optical path is integrally formed with the frame body 200 corresponding to the conventional holder for supporting the optical members, thereby reducing the number of components and enabling a simple assembly process.

It is desirable that the optical pointing device be reduced in size in accordance to the current size reduction trend of electrical devices. Therefore, interior components of the optical pointing device are fabricated to have very small sizes. According to the invention, it is possible to eliminate difficulty in assembling the small optical members, for example, prisms or mirrors, to the holder of the conventional optical pointing device, thereby simplifying the assembly process. In consequence, it is possible to prevent assembly deterioration and defects, which can occur when assembling such small components.

In this embodiment, the reflection part 310 includes reflective surfaces 311 a, 312a, which are integrally formed with the frame body 20 corresponding to the conventional holder. The reflective surfaces 311 a, 312a, are provided to surfaces of bases 311 b, 312b which are integrally formed with the frame body 200.

The frame body 200 and the bases 311 b, 312b may be integrally formed with each other by a mold or die. For example, the frame body 200 and the bases 311 b, 312b may be integrally formed with each other by injection molding. Then, by forming the reflective surfaces 311 a, 312a on the surfaces of the bases 311 b, 312b, the frame body 200 having the reflection part 310 integrally formed therewith can be fabricated.

The bases 311 b, 312b and the frame body 200 may be formed of various materials, such as plastics. The reflective surfaces 311 a, 312a may be integrally formed with the surfaces of the bases 311 b, 312b by polishing the surfaces of the bases 311 b, 312b or by depositing or coating a reflective material or reflective member on the surfaces of the bases 311 b, 312b.

The frame body 200 may be formed of an opaque plastic material, capable of blocking light, by injection molding. If the frame body 200 is formed of a transparent material, a light blocking material may be coated on a surface of the frame body 200.

The reflective material may include any metallic or non-metallic material, such as aluminum, silver, or the like, which has a high reflection coefficient. Alternatively, the reflective surfaces 311 a, 312a may be formed by attaching reflective films on the surfaces of the bases 311 b, 312b, respectively.

The reflection part 310 can provide a sufficient depth of focus through change of the optical path. In this embodiment, the reflection part 310 includes a first reflective portion 311 and a second reflective portion 312. More specifically, a pair of the bases 311 b, 312b is integrally formed with the frame body 200, and the reflective surfaces 311 a, 312a are integrally formed with the surfaces of the pair of bases 311 b, 312b, respectively.

As a result, the reflection part 310 includes a pair of reflective surfaces 311 a, 312a, which are disposed parallel to each other. The pair of reflective surfaces 311 a, 312a is provided to the surfaces of the pair of bases 311 b, 312b to be disposed at the same angle and parallel to each other.

To form the pair of reflective surfaces 311 a, 312a to be disposed at the same angle and parallel to each other on the surfaces of the pair of bases 311 b, 312b, the surfaces of the pair of bases 311 b, 312b are formed to be disposed at the same angle and parallel to each other, and the reflective surfaces 311 a, 312a are then formed to the same thickness on the surfaces of the pair of bases 311 b, 312b. In other words, the pair of reflective surfaces 311 a, 312a comprises the first reflective surface 311 a and the second reflective portion 312a which is located downstream of the first reflective surface 311 a.

The first reflective surface 311 a reflects light in a direction substantially parallel to a surface of the light receiving part 100, and the second reflective surface 312a reflects light in a direction perpendicular to the surface of the light receiving part 100.

In this embodiment, the first reflective surface 311 a reflects light perpendicular to the surface of the light receiving part 100 in the direction substantially parallel to the surface of the light receiving part 100, and the second reflective surface 312a reflects light substantially parallel to the surface of the light receiving part 100 in the direction substantially perpendicular to the surface of the light receiving part 100.

The first and second reflective surfaces 311 a, 312a are inclined at an angle of 45 degrees with respect to the surface of the light receiving part 100, and light reflected by the second reflective surface 312a is incident on the light receiving part 100. The optical unit 300 may further include at least one optical member attached to the frame body 200. More specifically, the optical unit 300 may further include an imaging lens 320. The imaging lens 320 is a convex lens and concentrates light traveling along the optical path.

The imaging lens 320 mounted on the frame body 200 is aligned in the optical path and is disposed between the pair of reflective surfaces 311 a, 312a. As a result, light traveling along the optical path enters the light receiving part 100 through the first reflective surface 311 a, the imaging lens 320, and the second reflective surface 312a.

The frame body 200 is formed with a mounting recess 210 on which the imaging lens 320 is mounted. The imaging lens 320 includes a lens portion 321 to concentrate light and a lens support 322 integrally formed with the lens portion 321 and inserted into the mounting recess 210. The frame body 200 is disposed inside a cover 400, which has an interface surface 400a for manipulating the optical pointing device. In other words, the cover 400 covers the frame body 200 and has the interface surface 400a.

The cover 400 includes a cover plate 410 that covers an upper side of the frame body 200 and is illuminated by a light source. The cover 400 may further include a cover rim 420 which surrounds the frame 200.

In this embodiment, the cover 400 has a cap shape open at the bottom thereof and has a space into which the frame body 200 is inserted. The cover plate 410 may have a flat or curved outer side surface and is formed with the interface surface 400a. The frame body 200 is inserted into the cover 400 and secured thereto.

The cover 400, particularly, the interface surface 400a, is illuminated by the light source 500, which is disposed inside the optical pointing device, more specifically, on the frame body 200. The light source 500 is mounted on a light source receiving groove 220 in the frame body 200 and is electrically connected to a printed circuit board 120 which is provided with the light receiving part 100.

The light receiving part 100 includes an image sensor 110, which is mounted on the printed circuit board 120. Here, the light source 500 is connected to the printed circuit board 120 via a flexible circuit board 510. It should be understood that the light source 500 may be directly mounted on the printed circuit board 120.

The printed circuit board 120 is provided at an upper side thereof with the frame body 200. In this embodiment, the printed circuit board 120 is coupled to a bottom of the cover 400 to form the bottom of the optical pointing device.

On the other hand, the light source 500 may be an IR source which emits infrared light. More specifically, the light source 500 may include an IR LED module which emits infrared light. Since the IR source emits infrared light, it does not cause fatigue to the eyes of a user, compared to a visible light source of high brightness, even when the eyes of the user are exposed to the infrared light for a long period of time.

Further, the cover 400, particularly, the interface surface 400a, may transmit light only in the infrared wavelength band. For this purpose, the cover plate 410 may include an IR band pass filter that transmits light only in the infrared wavelength band.

More specifically, to form the cover plate 410 including the IR band pass filter, the cover plate 410 may be formed of an optical glass or optical plastic that can transmit light only in the infrared wavelength band. Alternatively, the IR band pass film may be attached to a transparent glass or plastic or an IR band pass material may be coated thereon.

Further, a light blocking film or tape may be attached to the rest of the cover plate 410, excluding the region corresponding to the interface surface 400a, to block light. Alternatively, a light blocking material may be coated thereon to block light.

If the cover 400 further includes the cover rim 420, the cover rim 420 may also be formed of the light blocking material. The cover plate 410 and the cover rim 420 may be integrally formed by injection molding or may be formed by co-injection molding. Alternatively, the cover plate 410 and the cover rim 420 may be individually formed and coupled to each other.

In the optical pointing device according to this embodiment, infrared light emitted from the IR source 500 passes through the cover 400, particularly, the interface surface 400a of the cover plate 410, is reflected by an object, that is, a finger, and is finally introduced into the cover plate 410.

Here, since light, for example, ultraviolet light or visible light, in a predetermined wavelength band emitted from an external light source or the sun is blocked by the cover plate 410, exterior stray light can be minimized or prevented from reaching the light receiving part 100, thereby enhancing manipulation accuracy in response to movement of the object.

After being reflected into the cover plate 410, the IR light is reflected in the direction parallel to the surface of the light receiving part 100 by the first reflective surface and is concentrated through the imaging lens 320.

Then, the IR light having passed through the imaging lens 320 is reflected in the direction perpendicular to the light receiving part 100 by the second reflective surface 312a and reaches the image sensor.

As in second and third embodiments described below, the optical pointing device according to this embodiment may further include a light blocking part in the optical path to block a predetermined portion of light traveling along the optical path.

The light blocking part is disposed in the optical path and has a light passing portion formed to a predetermined size by reducing a cross-sectional area of the optical path through which the light passes. Then, a central part of the light traveling along the optical path passes through the light passing portion and a peripheral part of the light is blocked by the light blocking part.

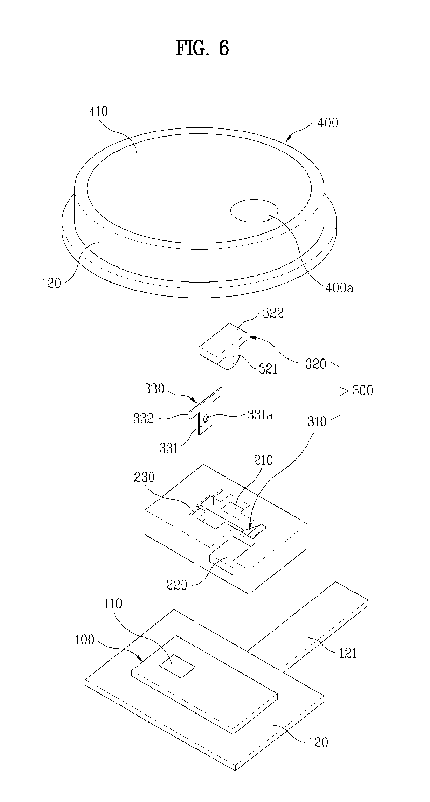

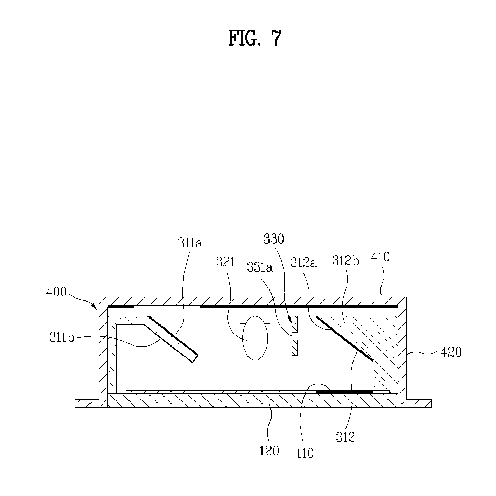

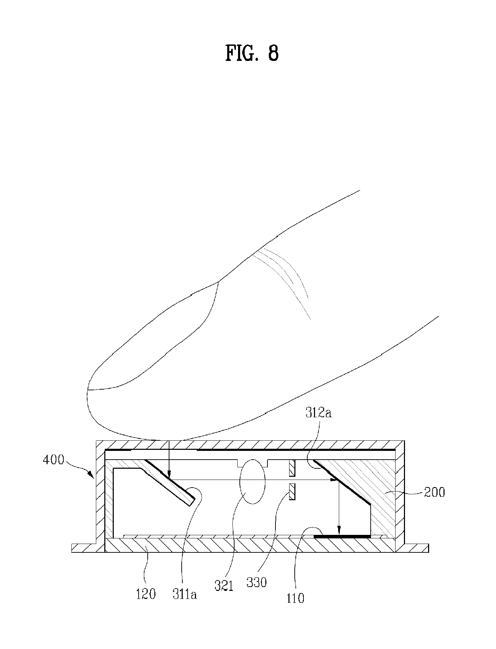

Next, an optical pointing device according to the second embodiment will be described with reference to Figs. 6 to 8.

In Figs. 6 to 8, the optical pointing device according to this embodiment includes a light receiving part 100, a frame body 200, and an optical unit 300. The optical unit 300 includes at least one reflection part 310 integrally formed with the frame body 200. The light receiving part 100, frame body 200 and optical unit 300 of this embodiment are similar to those of the first embodiment, and a repetitious description thereof will be omitted herein.

In this embodiment, the optical pointing device further includes a light blocking part 330 that blocks part of light traveling along an optical path. The light blocking part 330 is disposed in the optical path and has a light passing portion 331 a having a predetermined size, which is defined by reducing a cross-sectional area of the optical path through which light passes. The light shielding part 330 having the light passing portion 331 a functions as the iris of a camera lens which allows only part of light entering the lens to pass therethrough.

In other words, among light traveling along the optical path, only light passing through the light passing portion 331 a can reach the light receiving part 100 and the rest is blocked by the light blocking part 330.

The light blocking part 330 may be formed separately from the frame body 200 to be assembled thereto or may be integrally formed therewith.
In this embodiment, the light blocking part 330 is formed separately from the frame body 200 and is mounted thereon by a separate process. The frame body 200 is formed with an insertion slit 230 for mounting the light blocking part 330 on the frame body 200.

The light blocking part 330 includes a light blocking body 331 having the light passing portion 331 a defined therein and a body support 332 inserted into the insertion slit 230. The body support 332 is integrally formed with the light blocking body 331 and is inserted into the insertion slit 230 to support the light blocking body 331.

The light blocking part 330 may be disposed between the pair of reflective surfaces, but the position thereof is not limited thereto. If the optical unit 300 further includes an imaging lens 320, the light blocking part 330 is located at one side of the imaging lens 320. For example, the light blocking part 330 may be located downstream of the imaging lens 320.

The light blocking part 330 blocks stray light, which is dispersed to an outer periphery due to scattered reflection, scattering, diffusion and the like and lowers the recognition rate of the light receiving part 100, thereby improving operation accuracy of the optical pointing device according to the invention.

An example of the light blocking part 330 includes a plastic film capable of blocking light, that is, a light blocking film. The light blocking part may be formed of a metallic or non-metallic material. Here, the light passing portion 331 a may include a light passing hole that is formed by penetrating the light blocking film in a light traveling direction.

A center line of the light passing portion 331 a is collinear with the center line of the optical path. More specifically, the center line of the light passing portion 331 a is collinear with a central axis of the imaging lens 320. The size of the light passing portion 331 a may be set variously in accordance with a design.

Accordingly, part of light within a predetermined region on the center line of the light traveling along the optical path passes through the light passing portion 331 a and the rest of the light is blocked by the light blocking part 330.

The frame body 200 is protected by a cover 400 that has an interface surface 400a and is illuminated by a light source.

The light source and the cover 400 of this embodiment are the same as those of the first embodiment and a detailed description thereof will be omitted herein.

Operation of the optical pointing device according to this embodiment will hereinafter be described.

Infrared light emitted from the light source passes through the cover 400, particularly, the interface surface 400a of the cover plate, is reflected by an object (finger), and is finally introduced into the cover plate 410.

Here, since light, for example, ultraviolet light or visible light, in a predetermined wavelength band emitted from an external light source or the sun is blocked by the cover plate 410, exterior stray light can be minimized or prevented from reaching the light receiving part 100, thereby enhancing manipulation accuracy in response to movement of the object.

After being reflected into the cover plate 410, the IR light is reflected in the direction parallel to the surface of the light receiving part 100 by the first reflective surface 311 a and is concentrated through the imaging lens 320.

The IR light having passed through the imaging lens 320 reaches the second reflective surface 312a through the light passing portion 331 a. Here, a portion of the IR light outside a predetermined range on the center line of the IR light, that is, the IR light outside a radius of the light passing portion 331 a, is blocked by the light blocking part. Then, the IR light having reached the second reflective surface 312a is reflected by the second reflective surface 312a in a direction perpendicular to the light receiving part 100 and reaches the image sensor 110.

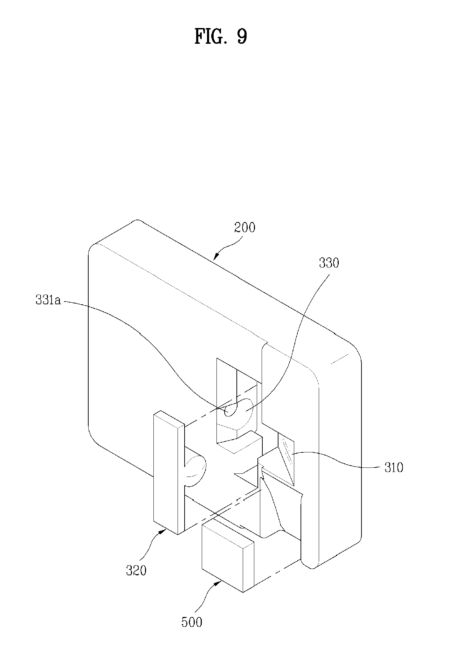

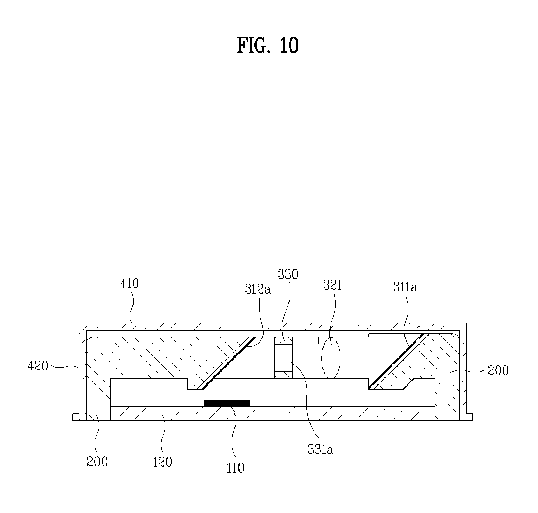

Next, referring to Figs. 9 and 10, an optical pointing device according to the third embodiment includes a light blocking part 330 that has the same configuration as that of the second embodiment but is integrally formed with the frame body 200. For example, the light blocking part 330 having a light passing portion 331 a may be integrally formed with the frame body 200 using the same material by injection molding. As a result, it is possible to simplify the assembly process through reduction in the number of components of the optical pointing device.

In this embodiment, the light passing portion 331 a may have a tapered inner side such that an inlet of the light passing portion 331 a is wider than an outlet thereof. Other components of the third embodiment are the same as those of the first and second embodiments and are denoted by the same reference numerals in the drawings, and a detailed description thereof is omitted herein.

The optical pointing device according to the embodiments of the invention may be directly mounted on an electronic device, for example, a portable electronic device. Alternatively, the optical pointing device may be provided separately from the electronic device and may be connected thereto via wired or wireless communication. Examples of the electronic device include PDAs, mobile terminals, GPSs, remote controllers, and the like.

In other words, the optical pointing device may be mounted on the electronic device 1 shown in Fig. 1, that is, on the body 2 of the electronic device 1 having the display screen 3, so as to be used as a user interface. Further, the optical pointing device according to the embodiments of the invention may be applied to other interfaces, such as a wired or wireless optical mouse.

The optical pointing device according to the embodiments and the electronic device including the same provide the following effects.

First, the optical pointing device includes an optical member for converting an optical path integrally formed with a frame body acting as the conventional holder, thereby significantly improving productivity through reduction in the number of components and simplification of an assembly process.

Second, the optical pointing device does not undergo assembly deterioration and defect which can occur during assembly of very small optical members, thereby reducing manufacturing costs and time.

Third, the optical pointing device can ensure a sufficient depth of focus through change of the optical path and is provided with a light blocking part that allows light in a predetermined range to pass therethrough, thereby improving operation accuracy of the optical pointing device. Further, when the light blocking part is integrally formed with the frame body, the assembly process can be further simplified.

Although some embodiments have been provided to illustrate the invention in conjunction with the drawings, it will be apparent to those skilled in the art that the embodiments are given by way of illustration only, and that various modifications, changes, and substitutions can be made without departing from the spirit and scope of the invention. The scope of the invention should be limited only by the accompanying claims and equivalents thereof.

## Claims

1. An optical pointing device comprising:
a light receiving part;
an optical unit transferring light to the light receiving part and comprising a reflection part disposed in an optical path;
a frame body integrally formed with the reflection part to support the reflection part;
a cover covering the frame body and having an interface surface; and
a light source illuminating the cover.

2. The optical pointing device according to claim 1, wherein the reflection part comprises a reflective surface integrated with a surface of a base integrally formed with the frame body.

3. The optical pointing device according to claim 1, wherein the reflection part comprises a pair of reflective surfaces integrated with surfaces of a pair of bases integrally formed with the frame body, the reflective surfaces being disposed at the same angle and parallel to each other.

4. The optical pointing device according to claim 3, wherein the pair of reflective surfaces comprises a first reflective surface reflecting light substantially perpendicular to a surface of the light receiving part in a direction substantially parallel to the surface of the light receiving part and a second reflective surface reflecting light substantially parallel to the surface of the light receiving part in a direction substantially perpendicular to the surface of the light receiving part.

5. The optical pointing device according to claim 2, wherein the reflective surface comprises a reflection film attached to the surface of the base or a reflection material coated on the surface of the base.

6. The optical pointing device according to claim 1, wherein the optical unit further comprises an imaging lens provided to the frame body.

7. The optical pointing device according to claim 6, wherein the reflection part comprises a pair of reflective surfaces integrated with surfaces of a pair of bases integrally formed with the frame body, the imaging lens being disposed between the reflective surfaces.

8. The optical pointing device according to claim 1, further comprising:
a light blocking part disposed in the optical path to block a predetermined portion of light traveling along the optical path, the light blocking part having a light passing portion formed to a predetermined size in the optical path by reducing a cross-sectional area of the optical path through which the light passes.

9. The optical pointing device according to claim 8, wherein the reflection part comprises a pair of reflective surfaces integrated with surfaces of a pair of bases integrally formed with the frame body, and the light blocking part is disposed between the reflective surfaces.

10. The optical pointing device according to claim 9, wherein the optical unit further comprises an imaging lens disposed between the reflective surfaces, and the light blocking part is disposed downstream of the imaging lens.

11. The optical pointing device according to claim 8, wherein the light blocking part is mounted on the frame body, the frame body being formed with an insertion slit to mount the light blocking part.

12. The optical pointing device according to claim 11, wherein the light blocking part comprises a light blocking body having the light passing portion formed therein and a body support integrally formed with the light blocking body to be inserted into the insertion slit.

13. The optical pointing device according to claim 11, wherein the light blocking part comprises a light blocking film and the light passing portion comprises a light passing hole formed through the light blocking film in a light traveling direction.

14. The optical pointing device according to claim 8, wherein the light passing portion has a center collinear with a center line of the optical path.

15. The optical pointing device according to claim 8, wherein the light blocking part is integrally formed with the frame body.

16. A portable electronic device comprising: a device body having a display screen; and an optical pointing device mounted on the device body, the optical pointing device comprising:
a light receiving part;
an optical unit transferring light to the light receiving part and including a reflection part disposed in an optical path; and
a frame body integrally formed with the reflection part to support the reflection part.
